# EUROPEAN PATENT APPLICATION

(11) **EP 2 482 619 A1**
(43) Date of publication of application: **01.08.2012**
(21) Application number: 10818881.4
(22) Date of filing: 24.09.2010
(51) Int. Cl.: H05B 33/12, H01L 51/50

(54) **ORGANIC ELECTROLUMINESCENT ELEMENT**

(30) Priority: 25.09.2009 JP 2009221589
(71) Applicant: Panasonic Corporation, Kadoma-shi Osaka 571-8501 (JP)
(72) Inventor: SASAKI, Hiroyuki, Osaka 540-6207 (JP)
(74) Representative: Appelt, Christian W.
(86) International application number: PCT/JP2010/066601
(87) International publication number: WO 2011/037209

(57) **Abstract**

Disclosed is a high-efficiency, long-life white-emission organic electroluminescent element, in particular, a white-emission organic electroluminescent element. The organic electroluminescent element of the present invention has a red phosphorescent light emitting-layer 12; a green phosphorescent light emitting-layer 11; a blue fluorescent light-emitting layer 22 and a green fluorescent light-emitting layer 21. A phosphorescent light unit 1 is formed by the red phosphorescent light emitting-layer 12 and the green phosphorescent light emitting-layer 11. A fluorescent light unit 2 is formed by the blue fluorescent light-emitting layer 22 and the green fluorescent light-emitting layer 21. The phosphorescent light unit 1 and the fluorescent light unit 2 are connected via an interlayer 3. Preferably, the phosphorescent light unit 1 is disposed further towards a cathode 4a side than the fluorescent light unit 2. Preferably, the emission color is any of a W color, a WW color and an L color.

## Description

### TECHNICAL FIELD

The present invention relates to an organic electroluminescent element, and more particularly to an organic electroluminescent element that is appropriate for white emission.

### BACKGROUND ART

It is known that organic electroluminescent elements are formed through stacking of an organic material layer, in the form of a single layer or a plurality of layers, between an electrode and another electrode. In such an organic electroluminescent element, one of the electrodes is an anode and the other electrode is a cathode, and voltage applied across both electrodes elicits recombination of electrons, which are injected and transported into the organic material layer from the cathode side, with holes that are injected and transported from the anode side. Light emission is obtained as a result of this recombination. Organic electroluminescent elements are thin light-emitting elements that afford surface emission, and that have received attention in recent years as constituents in light sources for various applications and in display units of self-luminous thin display devices.

Attempts have been made to achieve desired emission colors in organic electroluminescent elements, and, in particular, technologies have been proposed for achieving white-emission organic electroluminescent elements through combination of emission colors.

Japanese Patent Application Publication No. 2007-173827 discloses a white organic electroluminescent element that comprises a phosphorescent material that emits in red, a phosphorescent material that emits in green and a fluorescent material that emits in blue. However, this organic electroluminescent element was governed by the layer of the fluorescent material that emits in blue, and there occurred chromaticity changes in the emission of the element as a whole. The layer of this blue fluorescent material exhibited readily changes in chromaticity; this was accordingly problematic, in terms of life contingent on the amount of change in chromaticity, in that the life of the organic electroluminescent element was shortened. Also, white emission encompasses various specific hues, namely D, N, W, WW and L, and it was difficult to achieve emission in these various hues of white without incurring changes in chromaticity within the ranges of JIS standards.

### DISCLOSURE OF THE INVENTION

In the light of the above, it is an object of the present invention to provide an organic electroluminescent element, in particular a high-efficiency, long-life white-emission organic electroluminescent element, that boasts high emission efficiency, long life, and also good emission balance

The organic electroluminescent element of the present invention has a red phosphorescent light emitting-layer 12; a green phosphorescent light emitting-layer 11; a blue fluorescent light-emitting layer 22 and a green fluorescent light-emitting layer 21. The invention affords good emission balance, in particular, through generation of green emission by phosphorescent light and fluorescent light, and allows enhancing conversion efficiency from electric energy to light, and suppressing changes in luminance and chromaticity, even after prolonged emission. Therefore, an organic electroluminescent element can be obtained that has high emission efficiency and long life.

The organic electroluminescent element having the above configuration, preferably, has a phosphorescent light unit 1 that has the red phosphorescent light emitting-layer 12 and the green phosphorescent light emitting-layer 11, and a fluorescent light unit 2 that has the blue fluorescent light-emitting layer 22 and the green fluorescent light-emitting layer 21, wherein the phosphorescent light unit 1 and the fluorescent light unit 2 are connected via an interlayer 3. Such a configuration allows configuring an element out of a two-stage multi-unit, and hence there can be obtained an organic electroluminescent element having yet higher efficiency and longer life.

The organic electroluminescent element having the above configuration, preferably, has a phosphorescent light unit 1 that has the red phosphorescent light emitting-layer 12 and the green phosphorescent light emitting-layer 11; a fluorescent light unit 2 that has the blue fluorescent light-emitting layer 22 and the green fluorescent light-emitting layer 21; an anode 4b and a cathode 4a; wherein the phosphorescent light unit 1 is disposed further towards the cathode 4a side than the fluorescent light unit 2. In such a configuration, electrons can be injected to the phosphorescent light unit and holes to the fluorescent light unit. Emission efficiency can therefore be further increased.

The organic electroluminescent element having the above configuration, preferably, has a phosphorescent light unit 1 that has the red phosphorescent light emitting-layer 12 and the green phosphorescent light emitting-layer 11, and a fluorescent light unit 2 that has the blue fluorescent light-emitting layer 22 and the green fluorescent light-emitting layer 21; wherein, in the phosphorescent light unit 1, a ratio [I(λGT)/I(λRT)] of a maximum intensity [I(λRT)] at a red emission wavelength (λRT) and a maximum intensity [I(λGT)] at a green emission wavelength (λGT) satisfies I(λGT)/I(λRT)<0.65; and in the fluorescent light unit 2, a ratio [I(λGS)/I(λBS)] of a maximum intensity [I(λBS)] at a blue emission wavelength (λBS) and a maximum intensity [I(λGS)] at a green emission wavelength (λGS) satisfies T(λGS)/I(λBS)>0.3. Such a configuration allows improving the emission balance in the various units, and allows obtaining an organic electroluminescent element that boasts excellent emission balance, with small chromaticity changes.

The organic electroluminescent element having the above configuration, preferably, has a phosphorescent light unit 1 that has the red phosphorescent light emitting-layer 12 and the green phosphorescent light emitting-layer 11, and a fluorescent light unit 2 that has the blue fluorescent light-emitting layer 22 and the green fluorescent light-emitting layer 21; wherein an absolute value of a wavelength difference between a green emission wavelength (λGT) in the phosphorescent light unit 1 and a green emission wavelength (λGS) in the fluorescent light unit 2 is not greater than 10 nm. By bringing the green wavelength in the phosphorescent light unit close to the green wavelength in the fluorescent light unit, such a configuration allows increasing emission efficiency and prolonging life, and allows obtaining an organic electroluminescent element having yet higher efficiency and longer life.

In the organic electroluminescent element having the above configuration, preferably, the ionization potential (IpB) of an emitting dopant in the blue fluorescent light-emitting layer 22 is greater than the ionization potential (IpG) of an emitting dopant in the green fluorescent light-emitting layer 21, and the electron affinity (EaB) of an emitting dopant in the blue fluorescent light-emitting layer 22 is greater than the electron affinity (EaG) of an emitting dopant in the green fluorescent light-emitting layer 21. Such a configuration allows achieving an appropriate emission balance between blue and green, and allows increasing emission efficiency and prolonging life. Accordingly, there can be obtained an organic electroluminescent element having yet higher efficiency and longer life.

In the organic electroluminescent element having the above configuration, preferably, a mixed color of emission colors of the red phosphorescent light emitting-layer 12, the green phosphorescent light emitting-layer 11, the blue fluorescent light-emitting layer 22 and the green fluorescent light-emitting layer 21 is any of a W color, a WW color and an L color. Such a configuration allows prolonging emission life, and allows obtaining an organic electroluminescent element having yet longer life.

In the organic electroluminescent element having the above configuration, preferably, a maximum intensity (IR) in a red wavelength region, a maximum intensity (IG) in a green wavelength region and a maximum intensity (IB) in a blue wavelength region become, in this order, weaker (IR>IG>IB). By ranking the emission intensity in the order red, blue and green, such a configuration allows improving emission balance, and there can be obtained a high-efficiency, long-life organic electroluminescent element having yet better emission balance.

In the organic electroluminescent element having the above configuration, preferably, the red phosphorescent light emitting-layer 12 has a red phosphorescent emitting dopant that emits red phosphorescent light; and the red phosphorescent emitting dopant is formed of one substance selected from the group consisting of bis-(3-(2-(2-pyridyl)benzothienyl)mono-acetylacetonate)iridium (III), bis(2-phenylbenzothiazolato)(acetylacetonate)iridium (III) (Bt₂Ir(acac)), and 2,3,7,8,12,13,17,18-octaethyl-21H,23H-porphyrin platinum (II) (PtOEP). As a result, the red phosphorescent light emitting-layer 12 can reliably emit red phosphorescent light.

In the organic electroluminescent element having the above configuration, preferably, the green phosphorescent light emitting-layer 11 has a green phosphorescent emitting dopant that emits green phosphorescence; the green phosphorescent emitting dopant is formed of one substance selected from the group consisting of fac-tris(2-phenylpyridine)iridium, bis(2-phenylpyridine)(acetylacetonate)iridium (III) (Ir(ppy)₂₍acac)), and tris[2-(p-tolyl)pyridine]iridium (III) (Ir(mppy)₃). As a result, the green phosphorescent light emitting-layer 11 can reliably emit green phosphorescent light.

In the organic electroluminescent element having the above configuration, preferably, the blue fluorescent light-emitting layer 22 has a blue fluorescent emitting dopant that emits blue fluorescent light; wherein the blue fluorescent emitting dopant is formed of one substance selected from the group consisting of 1-tert-butyl perylene (TBP), 4,4'-bis(9-ethyl-3-carbazovinylene)-1,1'-biphenyl (BCzVBi), and perylene. Preferably, the blue fluorescent light-emitting layer 22 further has a charge transfer aid dopant; and the charge transfer aid dopant is formed of one substance selected from the group consisting of 4,4'-bis[N-(naphthyl)-N-phenyl-amino] biphenyl, N,N'-bis(3-methylphenyl)-N,N'-bis(phenyl)-benzidine (TPD), and N,N'-bis(3-methylphenyl)-N,N'-bis(phenyl)-9,9-spirobifluorene (Spiro-TAD). As a result, the blue fluorescent light-emitting layer 22 can reliably emit blue fluorescent light.

In the organic electroluminescent element having the above configuration, preferably, the green fluorescent light-emitting layer 21 has a green fluorescent emitting dopant that emits green fluorescent light; and the green fluorescent emitting dopant is formed of one substance selected from the group consisting of 2,3,6,7-tetrahydro-1,1,7,7,-tetramethyl-1H,5H,11H-10-(2-benzothiazolyl)quinolizino-[9,9a,1gh]coumarin (C545T), N,N'-dimethyl quinacridone (DMQA), coumarin 6, and rubrene. Preferably, a host into which the green fluorescent emitting dopant is incorporated is formed of one substance selected from the group consisting of tris (8-oxoquinoline)aluminum (III), 9,10-di-(2-naphthyl)anthracene (ADN) and bis(9,9'-diarylfluorene) (BDAF). Preferably, the doping concentration of the green fluorescent emitting dopant ranges from 1 to 20 mass%. As a result, the green fluorescent light-emitting layer 21 can reliably emit green fluorescent light.

### BRIEF DESCRIPTION OF THE DRAWINGS

Fig. 1 is a schematic cross-sectional diagram illustrating an example of an embodiment of organic electroluminescent element of the present invention;
Fig. 2 is a graph illustrating emission spectra of Examples 1 to 5;
Fig. 3 is a graph illustrating emission spectra of Comparative examples 1 to 5;
Fig. 4 is a graph illustrating emission spectra of Examples 6 to 10;
Figs. 5A and 5B are graphs illustrating emission spectra of evaluation elements for explaining the present invention;
Fig. 6 is a potential diagram for explaining energy levels, wherein A corresponds to Examples 1 to 5 and B corresponds to Examples 11 to 15; and
Fig. 7 is a graph illustrating the emission spectrum of rubrene.

### BEST MODE FOR CARRYING OUT THE INVENTION

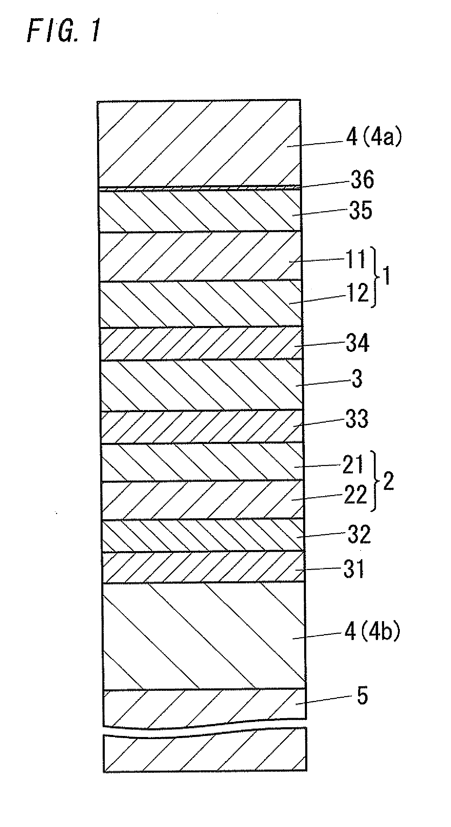

Fig. 1 illustrates an example of an embodiment of an organic electroluminescent element of the present invention. The organic electroluminescent element has a configuration wherein various stacked layers are sandwiched between a pair of electrodes 4, on the surface of a substrate 5 such as a glass substrate or the like. The organic electroluminescent element comprises a red phosphorescent light emitting-layer 12, a green phosphorescent light emitting-layer 11, a blue fluorescent light-emitting layer 22 and a green fluorescent light-emitting layer 21. Therefore, the emission color is formed by phosphorescent light of red and green colors, and fluorescent light of blue and green colors. Thus, light emission relies on phosphorescent light and fluorescent light. In particular, a good emission balance is achieved through adjustment of emission chromaticity and luminance, through generation of green emission as a result of two kinds of light emission, i.e. phosphorescence and fluorescence. Also, the conversion efficiency from electric energy to light can be enhanced, and changes in luminance and chromaticity can be curbed, even after prolonged emission. That is, the luminance life of green emission is extended through stacking of two green light-emitting layers, one of green phosphorescence and one of green fluorescence. Chromaticity changes can be reduced and life prolonged as a result.

The substrate 5, which supports the organic electroluminescent element, is formed of a material such as a glass substrate. The substrate 5 is preferably a transparent substrate in order to extract emitted light from the substrate 5 side.

The electrodes 4 are formed of a conductive material such as a metal or the like, and include the cathode 4a and the anode 4b. In the configuration of the figure, the anode 4b is formed as the layer in contact with the substrate 5. In order to extract emitted light towards the exterior, at least one of the electrodes 4 is formed as a transparent electrode. In the configuration of the figure, the anode 4b is formed as a transparent electrode, in such a manner that light is extracted at least from the substrate 5 side. The cathode 4a may be a transparent electrode, and light may be extracted from the side of the cathode 4a. Alternatively, light may be extracted through both electrodes 4.

The red phosphorescent light emitting-layer 12 and the green phosphorescent light emitting-layer 11 are formed as layers that come into contact with each other.
In the configuration of the figure, the red phosphorescent light emitting-layer 12 is formed on the anode 4b side, and the green phosphorescent light emitting-layer 11 is formed on the cathode 4a side. Thus, the phosphorescent light unit 1 is made up of two phosphorescent light-emitting layers.

The light-emitting layers of phosphorescent light (red phosphorescent light emitting-layer 12 and green phosphorescent light emitting-layer 11) are formed through doping, to an appropriate concentration, of a phosphorescent emitting dopant into a host material of the light-emitting layers. If a red emitting dopant is used as the emitting dopant, the red phosphorescent light emitting-layer 12 is obtained; if a green emitting dopant is used, the green phosphorescent light emitting-layer 11 is obtained.

The blue fluorescent light-emitting layer 22 and the green fluorescent light-emitting layer 21 are formed as layers that come into contact with each other. In the configuration of the figure, the blue fluorescent light-emitting layer 22 is disposed on the anode 4b side and the green fluorescent light-emitting layer 21 is disposed on the cathode 4a side. Thus, the fluorescent light unit 2 is made up of two fluorescent light-emitting layers.

The light-emitting layers of fluorescent light (blue fluorescent light-emitting layer 22 and green fluorescent light-emitting layer 21) are formed through doping, to an appropriate concentration, of a fluorescent emitting dopant into a host material of the light-emitting layers. If the emitting dopant is a blue emitting dopant, the blue fluorescent light-emitting layer 22 is obtained; if a green emitting dopant is used, the green fluorescent light-emitting layer 21 is obtained.

An interlayer 3 is formed between the phosphorescent light unit 1 and the fluorescent light unit 2. The interlayer 3 is formed of a conductive material such as a metal compound or a mixture of a metal compound and an organic material, and elicits smooth migration of electrons and holes between the light-emitting units. Thus, the phosphorescent light unit 1 and the fluorescent light unit 2 are electrically connected in series by way of the interlayer 3. Specifically, the phosphorescent light unit 1, the interlayer 3 and the fluorescent light unit 2 are disposed, not in parallel but in series, between the electrodes 4. Such an element structure is called a two-stage multi-unit. As a result, electrons and holes flow evenly in the light-emitting layers, and, in consequence, there is achieved well-balanced emission, coupled with high efficiency and long life. A two-stage multi-unit configuration facilitates layer stacking, which allows enhancing productivity.

The interlayer 3 may be a single layer or may comprise a plurality of layers. In case of a single layer, the element configuration is simpler, and it's production is easier. A multiple layer configuration allows using layer materials that are appropriate for electron transport and hole transport to the respective light-emitting units, and contributes to the greater efficiency and longer life.

The phosphorescent light unit 1 and the fluorescent light unit 2 are arranged in such a manner that the phosphorescent light unit 1 is disposed on the cathode 4a side and the fluorescent light unit 2 on the anode 4b side. That is, electrons are injected to the phosphorescent light unit 1, and holes to the fluorescent light unit 2. Emission efficiency is further enhanced in an element thus configured. Life can be prolonged if the phosphorescent light unit 1 is arranged on the anode 4b side and the fluorescent light unit 2 is arranged on the cathode 4a side, but emission efficiency drops in that case. Such a configuration is thus not a preferred one.

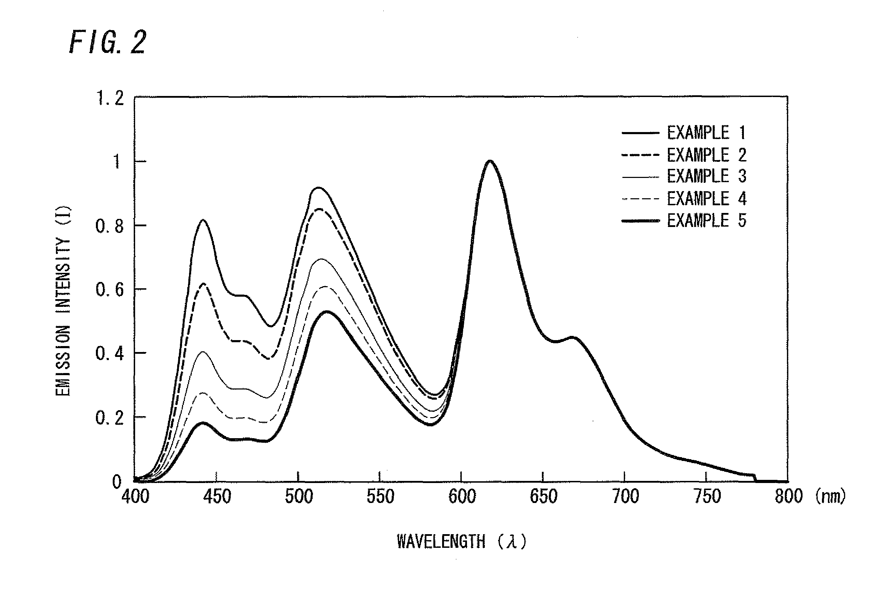

The emission spectrum of the organic electroluminescent element in the visible region (wavelength from about 400 to 800 nm) is observed (for instance, emission spectrum of Fig. 2) using an optical instrument such as a spectroradiometer. The emission spectrum gives the emission intensity, on a relative basis, for each wavelength. The organic electroluminescent element is configured using a blue emitting dopant having maximum emission intensity in a blue wavelength region (wavelength about 450 to 490 nm), a green emitting dopant having maximum emission intensity in a green wavelength region (wavelength about 500 to 570 nm) and a red emitting dopant having maximum emission intensity in a red wavelength region (wavelength about 590 to 650 nm), within the visible region. That is, various emission colors are obtained, and in particular white emission is obtained, by combining the primary colors red, green and blue.

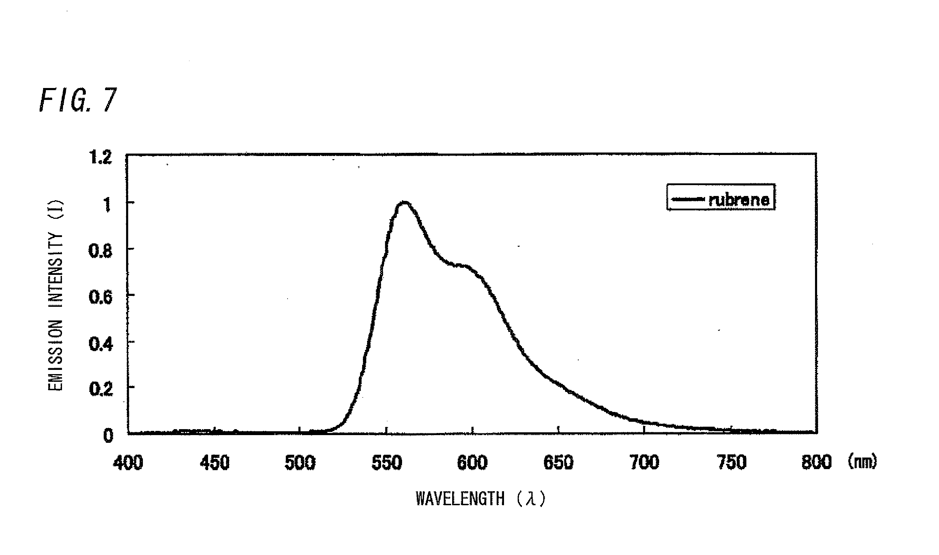

The color of the emitting dopant in the present invention is defined on the basis of the value of the wavelength that has maximum emission intensity, as described above. Colors may become indistinct, or dissimilar colors may be reproduced due to, for instance, spreading of the emission spectrum, but still emission color is best defined according to the abovementioned wavelengths. For instance, the emitting dopant rubrene emits visually yellow light (or yellow green emission), and may be referred thus to as a yellow emitting dopant, since the emission spectrum is spread significantly towards longer wavelengths. However, the maximum emission wavelength lies in the vicinity of 560 nm, and thus rubrene is classified as a green emitting dopant. The emission spectrum of rubrene is illustrated in Fig. 7, for reference.

Though grouped under a single term, white emission encompasses, in detail, various emission colors. In the field of illumination in particular, for instance in fluorescent lamps, color differences in white emission are a major issue. It is thus important to prescribe the emission color of an organic electroluminescent element that is to replace a fluorescent lamp, or that is to reproduce the hue of a fluorescent lamp.

Specific emission colors (hues) for white emission are given below.
Display: denomination: JIS standards (color temperature): color explanation
D: daylight color: 5700 to 7100 K: color of sunlight at noon on a clear day
N: Day white: 4600 to 5400 K; color of sunlight in a time band that spans noon on a clear day
W: white: 3900 to 4500 K: color of sunlight two hours after sunrise
WW: warm white: 3200 to 3700 K: color of evening sunlight
L: incandescent color: 2600 to 3150 K: color of a white light bulb
The above JIS standard is "JIS Z 9112, Classification of fluorescent lamps by chromaticity and color rendering property". The unit "K" of color temperature is "Kelvin".

By virtue of the above-described configurations, the organic electroluminescent element of the present invention allows achieving a good emission balance of red (R), green (G) and blue (B), and hence affords excellent white emission that conforms to JIS standards. Accordingly, the organic electroluminescent element of the present invention is particularly appropriate for white emission.

Preferably, the phosphorescent light unit 1 satisfies the expression below for the relationship (ratio) between a maximum intensity [I(λGT)] at a red emission wavelength (λRT), being a wavelength at which emission intensity is maximum in a red emission region, and a maximum intensity [I(λGT)] at a green emission wavelength (λGT) being a wavelength at which emission intensity becomes maximum in a green emission region.

### I(λGT)/T(λRT)<0.65

Preferably, the fluorescent light unit 2 satisfies at the same time the expression below for the relationship (ratio) between a maximum intensity [I(λBS)] at a blue emission wavelength (λBS) being a wavelength at which emission intensity is maximum in a blue emission region, and a maximum intensity [I(λGS)] at a green emission wavelength (λGS) being a wavelength at which emission intensity is maximum in a green emission region.

### I(λGS)/I(λBS)>0.3

Thus, a good emission balance between the respective emission colors of the respective units, i.e. green and red in the phosphorescent light unit 1, and blue and green in the fluorescent light unit 2, can be achieved by prescribing the relative intensities of the respective emission colors to satisfy the above numerical value relationships. Emission balance becomes poorer if the above relationships are not satisfied, and the desired emission color may fail to be obtained. Emission is thus maintained, unchanged, within the white range according to JIS standards, and a high-efficiency, long-life element is achieved, if the spectrum intensity relationships are as described above.

Preferably, the absolute value of the difference between the green emission wavelength (λGT) in the phosphorescent light unit 1 and the green emission wavelength (λGS) in the fluorescent light unit 2 is not greater than 10 nm. That is, there holds the relationship |λGT-λGS|≤10 (nm), which can be expressed also as -10≤λGT-λGS≤10. Emission efficiency can be increased, and life prolonged, by bringing the green wavelength in the phosphorescent light unit 1 and the green wavelength in the fluorescent light unit 2 close to each other.

The above relationships can be checked by producing evaluation elements of the elements of the respective units, and measuring the emission spectra of the elements.

Preferably, the ionization potential (IpB) of the emitting dopant (blue emitting dopant) of the blue fluorescent light-emitting layer 22 is greater than the ionization potential (IpG) of the emitting dopant (green emitting dopant) of the green fluorescent light-emitting layer 21. That is, there holds the relationship IpB>IpG.

At the same time, preferably, the electron affinity (EaB) of the emitting dopant (blue emitting dopant) of the blue fluorescent light-emitting layer 22 is greater than the electron affinity (EaG) of the emitting dopant (green emitting dopant) of the green fluorescent light-emitting layer 21. That is, there holds the relationship EaB>EaG.

An appropriate emission balance between blue and green can be obtained, while enhancing emission efficiency and prolonging life, by prescribing the energy levels of the emitting dopant of the blue fluorescent light-emitting layer 22, both for ionization potential (Ip) and electron affinity (Ea), to be higher than those of the emitting dopant of the green fluorescent light-emitting layer 21.

More preferably, the emission color of the organic electroluminescent element is any of W color (white), WW color (warm white) and L color (incandescent color), from among the abovementioned white types. The emission life can be prolonged as a result, and there can be obtained a long-life organic electroluminescent element. As described above, white emission encompasses various emission colors, but conventional organic electroluminescent elements were unable to sufficiently prevent small chromaticity changes. It was thus difficult to maintain the hue of white emission color, owing to chromaticity changes. In the organic electroluminescent element of the present invention, however, chromaticity changes are small, in particular if the emission color is W color, WW color or L color, and the hue of white emission can be maintained, and life prolonged.

In the emission spectrum of the organic electroluminescent element, preferably, a maximum intensity (IR) in a red wavelength region, a maximum intensity (IG) in a green wavelength region and a maximum intensity (IB) in a blue wavelength region become, in this order, weaker. That is, there holds the relationship IR>IG>IB. The emission balance improves as a result, and there can be obtained a high-efficiency, long-life organic electroluminescent element that boasts excellent emission balance.

In the organic electroluminescent element, layers for injection and/or transport electrons and injection and/or transport holes may be disposed between one of the electrodes 4 (cathode 4a) and the other electrode (anode 4b), as illustrated in Fig. 1. This affords smooth migration of electrons and holes, and contributes to improving efficiency and prolonging life.

In the configuration illustrated in the figure, a hole injection layer 31 and a hole transport layer 32 are stacked, in this order, between the anode 4b and the fluorescent light unit 2. An electron transport layer 33 is stacked between the fluorescent light unit 2 and the interlayer 3. A hole transport layer 34 is stacked between the interlayer 3 and the phosphorescent light unit 1. An electron transport layer 35 and an electron injection layer 36 are stacked, in this order, between the phosphorescent light unit 1 and the cathode 4a.

The layer build-up (stacking order) of the organic electroluminescent element is not limited to the configuration of Fig. 1. For instance, if in the configuration of Fig. 1 the injection layers and transport layers of electrons and holes are omitted, then the stacking order is substrate 5, anode 4b, fluorescent light unit 2, interlayer 3, phosphorescent light unit 1 and cathode 4a, from the bottom of the figure. However, a reversed configuration, namely substrate 5, cathode 4a, phosphorescent light unit 1, interlayer 3, fluorescent light unit 2 and anode 4b is also possible.

As regards the film thickness of the light-emitting layers, the film thickness of the red phosphorescent light emitting-layer 12 can be set to range from about 5 to 40 nm, the film thickness of the green phosphorescent light emitting-layer 11 to range from about 5 to 40 nm, the film thickness of the blue fluorescent light-emitting layer 22 to range from about 5 to 40 nm, and the film thickness of the green fluorescent light-emitting layer 21 to range from about 5 to 40 nm. As regards film thickness ratios, the film thickness of the red phosphorescent light emitting-layer 12 and the film thickness of the green phosphorescent light emitting-layer 11 can be set to range from about 1: 8 to 8: 1, and the film thickness of the blue fluorescent light-emitting layer 22 and to the film thickness of the green fluorescent light-emitting layer 21 can be set to range from about 1: 8 to 8: 1. The film thickness of the fluorescent light unit 2 and the film thickness of the phosphorescent light unit 1 can be set to range from about 1: 3 to 3: 1. The film thickness of the interlayer 3 can be set to range from about 3 to 50 nm. High efficiency and long life can be conferred to the organic electroluminescent element by setting film thicknesses as described above.

Examples of the materials of the various layers are explained below. The present invention is not limited to these material examples.

In the electrodes 4, an electrode material comprising a metal, an alloy, an electrically conductive compound, or mixture of the foregoing, having a large work function, is preferably used in the electrode 4 (anode 4b) that is in contact with the substrate 5. As such materials of the anode 4b there can be used, for instance, a conductive light-transmitting material, for instance a metal such as gold; CuI, ITO (indium-tin oxide), SnO₂, ZnO, IZO (indium - zinc oxide) or the like; a conductive polymer such as PEDOT or polyaniline, or a doped conductive polymer, for instance doped with an arbitrary acceptor; or carbon nanotubes. As the material of the other electrode 4 (cathode 4a), there is preferably used a metal, alloy, electrically conductive compound, or mixture of the foregoing, having a small work function. Examples of such materials of the cathode 4a include, for instance, alkali metals and alkaline earth metals, and alloys of these metals with other metals, for instance sodium, sodium-potassium alloys, lithium, magnesium, magnesium-silver mixtures, magnesium-indium mixtures or aluminum-lithium alloys. The conductive materials such as metals or the like may be used stacked in one or more layers. Examples of such stacks include, for instance, an alkali metal/Al stack, an alkaline earth metal/Al stack, an alkaline earth metal/Ag stack, a magnesium-silver alloy/Ag stack or the like. A transparent electrode typified by ITO, IZO or the like may be used, such that light may be extracted from the cathode 4a side.

For instance, CBP, CzTT, TCTA, mCP or CDBP may be used as a light-emitting layer host in the green phosphorescent light emitting-layer 11. As the green phosphorescent emitting dopant there can be used, for instance Ir(ppy)₃, Ir(ppy)₂(acac), Ir(mppy)₃ or the like. The doping concentration ranges ordinarily from 1 to 40 mass%.

For instance, CBP, CzTT, TCTA, mCP, CDBP or the like may be used as a light-emitting layer host in the red phosphorescent light emitting-layer 12. As the phosphorescent light red emitting dopant there can be used, for instance, Btp₂Ir(acac), Bt₂Ir(acac), PtOEP or the like. The doping concentration ranges ordinarily from 1 to 40 mass%.

For instance, Alq₃, ADN, BDAF or the like may be used as the light-emitting layer host in the green fluorescent light-emitting layer 21. As the green fluorescent emitting dopant there can be used, for instance, C545T, DMQA, coumarin 6, rubrene or the like. The doping concentration ranges ordinarily from 1 to 20 mass%.

For instance, TBADN, ADN, BDAF or the like may be used as the light-emitting layer host in the blue fluorescent light-emitting layer 22. As the blue fluorescent emitting dopant there can be used, for instance, TBP, BCzVBi, perylene or the like. As the charge transfer aid dopant there can be used, for instance, NPD, TPD, Spiro-TAD or the like. The total doping concentration of the combined emitting dopants and charge transfer aid dopant ranges ordinarily from 1 to 30 mass%.

As the interlayer 3 there can be used, for instance, BCP: Li, ITO, NPD: MoO₃, Liq: Al or the like. For instance, the interlayer 3 may have a two-layer build-up wherein a first layer comprising BCP: Li is disposed on the anode 4b side, and a second layer comprising ITO is disposed on the cathode 4a side.

As the hole injection layer 31 there can be used, for instance, CuPc, MTDATA, TiOPC or the like.

As the hole transport layers 32, 34 there can be used, for instance, TPD, NPD, TPAC, DTASi or the like.

As the electron transport layers 33, 35 there can be used, for instance, BCP, TAZ, BAlq, Alq₃, OXD7, PBD or the like.

As the electron injection layer 36 there can be used a layer doped with a fluoride, oxide or carbonate of an alkali metal or alkaline earth metal, for instance LiF, Li₂O, MgO, Li₂CO₃ or the like; or an organic material layer doped with an alkali metal or alkaline earth metal such as lithium, sodium, cesium, calcium or the like.

### Among the other materials,

Bt₂Ir(acac) represents bis(2-phenylbenzothiazolato)(acetylacetonate)iridium (III),
PtOE represents 2,3,7,8,12,13,17,18-octaethyl-21H,23H-porphyrin platinum (II);
Ir(ppy)₂(acac) represents bis(2-phenylpyridine)(acetylacetonate)iridium (III);
Ir(mppy)₃ represents tris[2-(p-tolyl)pyridine]iridium (III);
BCzVBi represents 4,4'-bis(9-ethyl-3-carbazovinylene)-1,1'-biphenyl;
TPD represents N,N'-bis(3-methylphenyl)-N,N'-bis(phenyl)-benzidine;
Spiro-TAD represents N,N'-bis(3-methylphenyl)-N,N'-bis(phenyl)-9,9-spirobifluorene;
C545T represents 2,3,6,7-tetrahydro-1,1,7,7,-tetramethyl-1H,5H,11H-10-(2-benzothiazolyl)quinolizino-[9,9a,1gh]coumarin;
DMQA represents N,N'-dimethyl-quinacridone;
ADN represents 9,10-di-(2-naphthyl)anthracene;
BDAF represents bis(9,9'-diarylfluorene);
CBP represents 4,4'-N,N'-dicarbazolebiphenyl;
Alq₃ represents tris (8-oxo-quinoline)aluminum (III);
TBADN represents 2-t-butyl-9,10-di(2-naphthyl)anthracene;
Ir(ppy)₃ represents fac-tris(2-phenylpyridine)iridium;
Btp₂Ir(acac) represents bis-(3-(2-(2-pyridyl)benzothienyl)mono-acetylacetonate)iridium(III));
C545T represents coumarin C545T, 10-2-(benzothiazolyl)-2,3,6,7-tetrahydro-1,1,7,7-tetramethyl-1H,5H,11H-(1)benzopyropyrano(6,7-8-I,j)quinolizin-11-one;
TBP represents 1-tert-butyl perylene;
NPD represents 4,4'-bis[N-(naphthyl)-N-phenyl-amino]biphenyl;
BCP represents 2,9-dimethyl-4,7-diphenyl-1,10-phenanthroline;
CuPc represents copper phthalocyanine; and
TPD represents N,N'-bis(3-methylphenyl)-(1,1'-biphenyl)-4,4'-diamine.

The organic electroluminescent element can be obtained through layering of the various layers using the above-described materials. The layering method that is used may be, for instance, vacuum vapor deposition or sputtering.

### Examples

Examples of the present invention are explained next.

### [Production of organic electroluminescent elements]

Organic electroluminescent elements of examples and comparative examples were produced according to the procedure below.

The anode 4b having a sheet resistance of 10 Q/square was formed, by sputtering of ITO (indium-tin oxide) onto a 0.7 mm-thickness glass substrate, as the substrate 5, to produce a glass substrate provided with ITO. The glass substrate provided with ITO was subjected to ultrasonic cleaning for 15 minutes with acetone, pure water and isopropyl alcohol, and was then dried and cleaned using UV ozone. The glass substrate provided with ITO was then set in a vacuum vapor deposition apparatus, and various organic or inorganic layers were sequentially vapor-deposited, through resistance heating, under a degree of vacuum of 5×10⁻⁵ Pa or less. Lastly, Al was vapor-deposited to form the cathode 4a.

### (Device structure of the organic electroluminescent elements)

### (Examples 1 to 5)

The device structure (layer build-up) and film thickness of the various layers are given below. The layer build-up in Examples 1 to 5 is identical to that of Fig. 1. However, the interlayer 3 comprises two layers, namely a first layer and a second layer.
Substrate 5: glass substrate (0.7 mm)
Anode 4b: ITO (150 nm)
Hole injection layer 31: CuPc (30 nm)
Hole transport layer 32: TPD (30 nm)
Blue fluorescent light-emitting layer 22: TBADN: TBP: NPD (X nm)
Green fluorescent light-emitting layer 21: Alq₃: C545T (Y nm)
Electron transport layer 33: BCP (30 nm)
Interlayer 3 (first layer): BCP: Li (10 nm)
Interlayer 3 (second layer): ITO (10 nm)
Hole transport layer 34: TPD (30 nm)
Red phosphorescent light emitting-layer 12: CBP: Btp₂Ir(acac) (α nm)
Green phosphorescent light emitting-layer 11: CBP: Ir(ppy)₃ (β nm)
Electron transport layer 35: BCP (20 nm)
Electron injection layer 36: LiF (1 nm)
Cathode 4a: Al (80 nm)
The various light-emitting layers in the above organic electroluminescent element are explained in detail below.

In the blue fluorescent light-emitting layer 22, a light-emitting layer host: TBADN was doped with 1.5% of a blue emitting dopant: TBP and with 5% of a charge transfer aid dopant: NPD.

In the green fluorescent light-emitting layer 21, a light-emitting layer host: Alq₃ was doped with 1.5% of a green emitting dopant: C545T.

In the red phosphorescent light emitting-layer 12, a light-emitting layer host: CBP was doped with 10% of a red emitting dopant: Btp₂Ir(acac).

In the green phosphorescent light emitting-layer 11, a light-emitting layer host: CBP was doped with 10% of a green emitting dopant: Ir(ppy)₃.

In the present invention, the units "%" of doping concentration refer to "mass%".

The film thicknesses X, Y, α, β of the various light-emitting layers are shown in Table 1.

### (Comparative examples 1 to 5)

The device structure (layer build-up) and film thickness of the various layers in Comparative examples 1 to 5 are given below.
Substrate 5: glass substrate (0.7 mm)
Anode 4b: ITO (150 nm)
Hole injection layer 31: CuPc (30 nm)
Hole transport layer 32: TPD (30 nm)
Blue fluorescent light-emitting layer 22: TBADN: TBP: NPD (X nm)
Electron transport layer 33: BCP (30 nm)
Interlayer 3 (first layer): BCP: Li (10 nm)
Interlayer 3 (second layer): ITO (10 nm)
Hole transport layer 34: TPD (30 nm)
Red phosphorescent light emitting-layer 12: CBP: btp₂Ir(acac) (α nm)
Green phosphorescent light emitting-layer 11: CBP: Ir(ppy)₃ (β nm)
Electron transport layer 35: BCP (20 nm)
Electron injection layer 36: LiF (1 nm)
Cathode 4a: Al (80 nm)
The organic electroluminescent elements in the comparative examples have the configuration of the organic electroluminescent elements of the examples, but with the green fluorescent light-emitting layer 21 removed therefrom, and are close to the layer build-up concept of the Japanese Patent Application Publication No. 2007-173827. The film thickness of the various light-emitting layers is adjusted in order to adjust the emission color. The details of the various light-emitting layers are identical to those of the examples. The film thicknesses X, α, β of the various light-emitting layers are shown in Table 1.

### (Examples 6 to 10)

The organic electroluminescent elements in Examples 6 to 10 were produced in the same way as in Examples 1 to 5, but herein the green fluorescent light-emitting layer 21 of the fluorescent light unit 2 in the organic electroluminescent elements of Examples 1 to 5 was as follows.

### Green fluorescent light-emitting layer 21: Alq₃: rubrene (Y nm)

In the green fluorescent light-emitting layer 21, a light-emitting layer host: Alq₃ was doped with 2% of a green emitting dopant: rubrene. The green fluorescent light-emitting layer 21 utilizes rubrene, which gives rise to visually yellow emission, and thus is also referred to as a yellow fluorescent light-emitting layer. The film thicknesses are as shown in Table 1.

### (Examples 11 to 15)

Organic electroluminescent elements in Examples 11 to 15 were produced in the same way as in Examples 1 to 5, but herein the green fluorescent light-emitting layer 21 of the fluorescent light unit 2 in the organic electroluminescent elements of Examples 1 to 5 was as follows.

### Green fluorescent light-emitting layer 21: Alq₃: coumarin 6 (Y nm)

In the green fluorescent light-emitting layer 21, a light-emitting layer host: Alq₃ was doped with 2% of a green emitting dopant: coumarin 6 (λmax=510 nm) . The film thicknesses are as shown in Table 1

### (Example 16)

The device structure (layer build-up) and film thickness of the various layers in Example 16 are given below.
Substrate 5: glass substrate (0.7 mm)
Anode 4b: ITO (150 nm)
Hole injection layer 31: CuPc (30 nm)
Hole transport layer 32: TPD (30 nm)
Red phosphorescent light emitting-layer 12: CBP: btp₂Ir(acac) (30 nm)
Green phosphorescent light emitting-layer 11: CBP: Ir(ppy)₃ (10 nm)
Electron transport layer 33: BCP (30 nm)
Interlayer 3 (first layer): BCP: Li (10 nm)
Interlayer 3 (second layer): ITO (10 nm)
Hole transport layer 34: TPD (30 nm)
Blue fluorescent light-emitting layer 22: TBADN: TBP: NPD (20 nm)
Green fluorescent light-emitting layer 21: Alq₃: C545T (15 nm)
Electron transport layer 35: BCP (20 nm)
Electron injection layer 36: LiF (1 nm)
Cathode 4a: Al (80 nm)
The organic electroluminescent element of Example 16 is configured as the organic electroluminescent element of Example 4, but herein the phosphorescent light unit 1 and the fluorescent light unit 2 are swapped. As a result, it is possible to evaluate element characteristics resulting from differences in stacking order.

**[Table 1]**

| | | | | | |
|---|---|---|---|---|---|
| (units: nm) | | | | | |

| | Example 1 | Example 2 | Example 3 | Example 4 | Example 5 |
|---|---|---|---|---|---|
| X | 25 | 25 | 25 | 20 | 15 |
| Y | 5 | 5 | 10 | 15 | 20 |
| α | 15 | 18 | 25 | 30 | 35 |
| β | 15 | 17 | 10 | 10 | 10 |

| | Comparative example 1 | Comparative example 2 | Comparative example 3 | Comparative example 4 | Comparative example 5 |
|---|---|---|---|---|---|
| X | 30 | 30 | 25 | 15 | 10 |
| Y | - | - | - | - | - |
| α | 10 | 15 | 20 | 25 | 30 |
| β | 20 | 20 | 15 | 10 | 10 |

| | Example 6 | Example 7 | Example 8 | Example 9 | Example 10 |
|---|---|---|---|---|---|
| X | 25 | 25 | 25 | 20 | 15 |
| Y | 5 | 5 | 10 | 15 | 20 |
| α | 15 | 18 | 25 | 30 | 35 |
| β | 15 | 17 | 10 | 10 | 10 |

| | Example 11 | Example 12 | Example 13 | Example 14 | Example 15 |
|---|---|---|---|---|---|
| X | 25 | 25 | 25 | 20 | 15 |
| Y | 5 | 5 | 10 | 15 | 20 |
| α | 15 | 18 | 25 | 30 | 35 |
| β | 15 | 17 | 10 | 10 | 10 |

### [Measurements]

### (Emission spectra)

The emission spectrum of each organic electroluminescent element was measured using a spectroradiometer (CS-2000 by Konica Minolta).

### (Efficiency)

The organic electroluminescent elements were connected to a power source (KEYTHLEY2400), a constant current of current density 10 mA/cm² was caused to pass through the elements, and power efficiency was measured using an integrating sphere (SLMS-CDS, by Labsphere).

### (Life)

The organic electroluminescent elements were connected to a power source (KEYTHLEY2400), a constant current of current density 10 mA/cm² was caused to pass through the elements, and luminance upon continuous emission was observed using a luminance meter (LS-110, by Konica Minolta), to measure the half-time at which luminance dropped by half. At the same time, changes in emission chromaticity were observed, and emission chromaticity was compared with initial emission chromaticity, to measure the color change time by which the amount of change in chromaticity was 0.01 or greater. The element life was taken as the shorter time from among the time by which luminance dropped by half (half-time), and the time by which the amount of change in chromaticity was 0.01 or greater (color change time).

### [Comparison of organic electroluminescent elements]

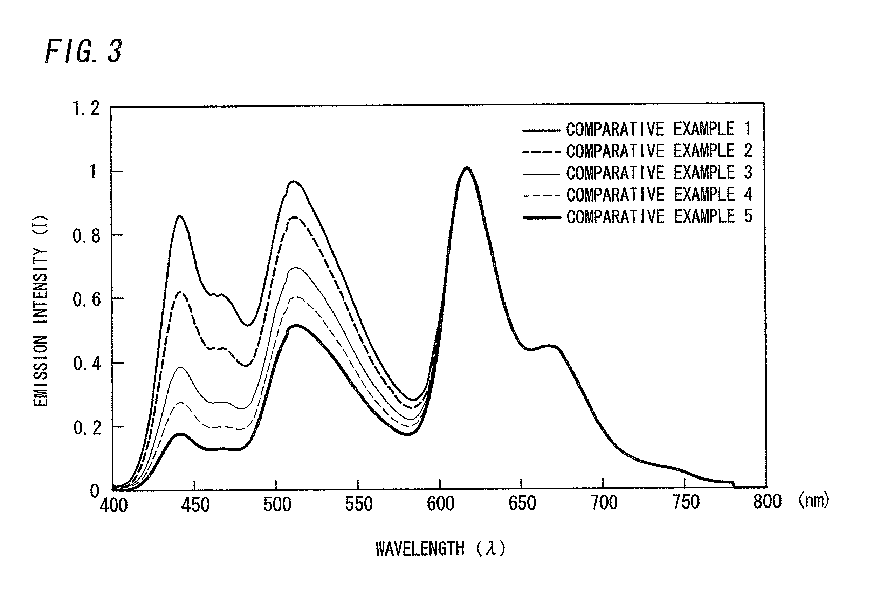

Fig. 2 illustrates emission spectra of the organic electroluminescent elements of Examples 1 to 5. Fig. 3 illustrates emission spectra of the organic electroluminescent elements of Comparative examples 1 to 5. In the emission spectra, the maximum emission intensity in the red wavelength region is normalized to "1".

Table 2 shows the emission colors and CIE chromaticity coordinates of the examples and comparative examples, and results (efficiency and life) of a comparison, between the examples and the comparative examples, for each emission color. For one same emission color, efficiency and life in an example is taken as "I", and efficiency and life in the comparative example is expressed as a relative value (In Comparative example 1, for instance, comparison vis-a-vis Example 1).

Herein, CIE chromaticity coordinates refer, more precisely, to the x,y coordinate values in the "CIE1931 chromaticity diagram". In Table 2, the x coordinate value in the CIE1931 chromaticity diagram is notated as "CIE-x", and the y coordinate value in the CIE1931 chromaticity diagram is notated as "CIE-y". An emission color can be designated by the x,y coordinate values in the CIE1931 chromaticity diagram. The feature wherein the x,y coordinate values of the examples and the comparative examples are close to each other, for each emission color (D to L colors) in Table 2, means that substantially identical emission colors are brought out. For instance, the D color comes under a single denomination, but the range that can be referred to as D color is wide. Therefore, current efficiency (power efficiency) is increased, in a relationship vis-a-vis luminous efficiency, by designing a greenish (above the black body locus) emission color, also for organic electroluminescent elements that exhibit the same external quantum efficiency. By explicitly setting forth the coordinate values in the CIE1931 chromaticity diagram, it becomes thus possible to represent not just the hue, but also a more rigorous "identical emission color", and it becomes more feasible to compare efficiency and/or life for a same emission color.

As Table 2 indicates, life was prolonged, in all examples, beyond that in the comparative examples, for a same emission color. Also, efficiency was enhanced vis-a-vis that in the comparative examples, particularly in Example 3 (W color), Example 4 (WW color) and Example 5 (L color).

**[Table 2]**

| Emission color | D | N | W | WW | L |
|---|---|---|---|---|---|
| | Example 1 | Example 2 | Example 3 | Example 4 | Example 5 |
| CIE-x | 0.325 | 0.346 | 0.381 | 0.41 | 0.44 |
| CIE-y | 0.337 | 0.36 | 0.378 | 0.395 | 0.407 |
| Efficiency | 1 | 1 | 1 | 1 | 1 |
| Life | 1 | 1 | 1 | 1 | 1 |

| | Comparative example 1 | Comparative example 2 | Comparative example 3 | Comparative example 4 | Comparative example 5 |
|---|---|---|---|---|---|
| CIE-x | 0.321 | 0.346 | 0.383 | 0.41 | 0.44 |
| CIE-y | 0.336 | 0.358 | 0.381 | 0.393 | 0.404 |
| Efficiency | 1.09 | 1.09 | 0.93 | 0.88 | 0.84 |
| Life | 0.82 | 0.82 | 0.79 | 0.76 | 0.65 |

| | | | | | |
|---|---|---|---|---|---|
| * Efficiency and life values in the comparative examples are relative values with respect to 1 for efficiency and life in the examples overhead | | | | | |

Table 3 shows the relative intensity between the maximum emission intensity (IR) in a red wavelength region, the maximum emission intensity (IG) in a green wavelength region, and a maximum emission intensity (IB) in a blue wavelength region, in Examples 1 to 5. The wavelengths that exhibit maximum emission intensity for each color are as follows.

Blue: λ(blue): 462 nm
Green: λ(green): 525 nm
Red: λ(red): 620 nm
Table 3 explains that intensity in the emission spectra obtained in Examples 1 to 5 was strongest for red, and then for green and blue, in this order. For all examples, the wavelengths in Table 3 are relative values referred to 1 for the maximum emission intensity (IR) in the red wavelength region.

**[Table 3]**

| | Wavelength | Example 1 | Example 2 | Example 3 | Example 4 | Example 5 |
|---|---|---|---|---|---|---|
| IB | λ(blue) | 0.81 | 0.61 | 0.4 | 0.28 | 0.18 |
| IG | λ(green) | 0.92 | 0.85 | 0.69 | 0.61 | 0.53 |
| IR | λ(red) | 1 | 1 | 1 | 1 | 1 |

Table 4 shows the results of a comparison between Example 16 and Example 4. The table explains that Example 16, in which the fluorescent light unit 2 was disposed on the cathode 4a side and the phosphorescent light unit 1 was disposed on the anode 4b side, exhibited a substantially the same life, but lower efficiency, than Example 4. That is, Example 4, in which the phosphorescent light unit 1 was disposed on the cathode 4a side, was found to exhibit higher efficiency.

**[Table 4]**

| Emission color | WW | WW |
|---|---|---|
| | Example 4 | Example 16 |
| Efficiency | 1 | 0.74 |
| Life | 1 | 0.93 |

| | | |
|---|---|---|
| * Relative values with respect to 1 for efficiency and life in Example 4 | | |

The characteristics of the various light-emitting units are explained next.

Elements in each of the light-emitting units used in Examples 1 to 5 were produced as evaluation elements. The layer build-up and the thicknesses of the various layers in the evaluation elements are as follows.

### <Fluorescent light unit evaluation element: evaluation elements 1 to 5>

Substrate 5: glass substrate (0.7 mm)
Anode 4b: ITO (150 nm)
Hole injection layer 31: CuPc (30 nm)
Hole transport layer 32: TPD (30 nm)
Blue fluorescent light-emitting layer 22: TBADN: TBP: NPD (X nm)
Green fluorescent light-emitting layer 21: Alq₃: C545T (Y nm)
Electron transport layer 33: BCP (30 nm)
Electron injection layer 36: LiF (1 nm)
Cathode 4a: Al (80 nm)

### <Phosphorescent light unit evaluation element: evaluation elements 6 to 10>

Substrate 5: glass substrate (0.7 mm)
Anode 4b: ITO (150 nm)
Hole injection layer 31: CuPc (30 nm)
Hole transport layer 34: TPD (30 nm)
Red phosphorescent light emitting-layer 12: CBP: btp₂Ir(acac) (α nm)
Green phosphorescent light emitting-layer 11: CBP: Ir(ppy)₃ (β nm)
Electron transport layer 35: BCP (20 nm)
Electron injection layer 36: LiF (1 nm)
Cathode 4a: Al (80 nm)
The thicknesses in the various evaluation elements are summarized in Table 5. The thicknesses in Evaluation elements 1 to 5 and of Evaluation elements 6 to 10 correspond respectively to the thicknesses in Examples 1 to 5.

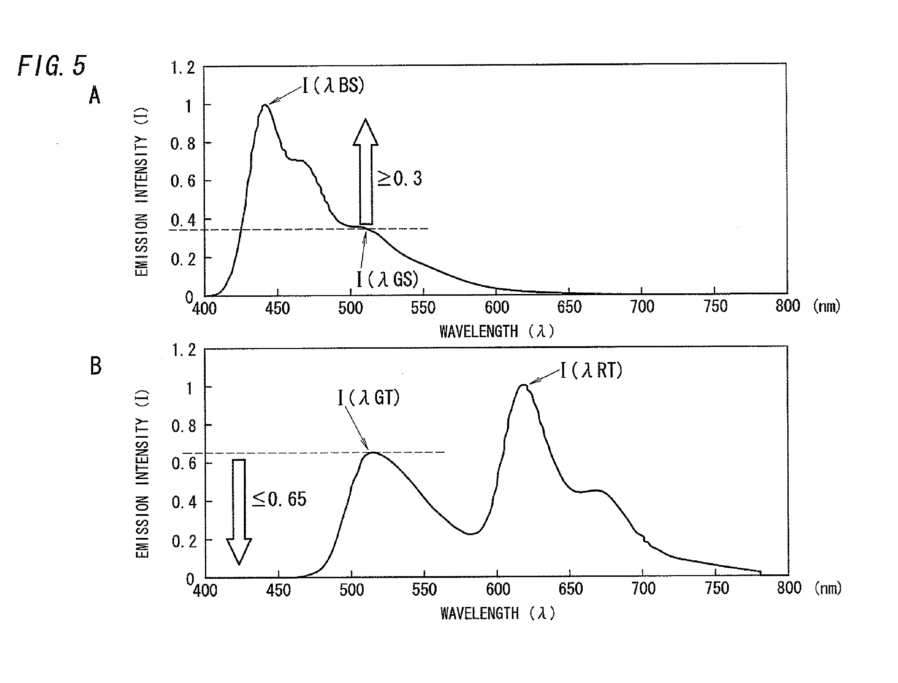

The emission spectra of the evaluation elements were measured, and emission intensities were compared among the emission colors (blue, green and red). Fig. 5A illustrates the emission spectrum of Evaluation element 1, which is a fluorescent light unit evaluation element, and Fig. 5B illustrates the emission spectrum of evaluation element 6, which is a phosphorescent light unit evaluation element.

Table 5 shows the relative emission intensity of the various evaluation elements. In the fluorescent light unit evaluation element, the maximum emission intensity in the blue wavelength region is set to "1", and the maximum emission intensity of the green wavelength region is expressed as a relative intensity. In the phosphorescent light unit evaluation element, the maximum emission intensity in the red wavelength region is set to "1", and the maximum emission intensity of the green wavelength region is expressed as a relative intensity. The units of thickness in Table 5 are nm.

As the tables and the emission spectra reveal, the relationship between maximum emission intensity [I(λBS)] at the blue emission wavelength (λBS) and maximum emission intensity [I(λGS)] at the green emission wavelength (λGS) obeys [I(λGS)]/[I(λBS)]>0.3, for the fluorescent light unit evaluation elements (Evaluation elements 1 to 5).

Also, the relationship between maximum intensity [I(λRT)] at the red emission wavelength (λRT) and maximum intensity [I(λGT)] at the green emission wavelength (λGT) obeys [I(λGT)]/[I(λRT)1<0.65 for the phosphorescent light unit evaluation elements (Evaluation elements 6 to 10).

Therefore, it was found that the emission intensity in the fluorescent light unit 2 and the phosphorescent light unit 1 in Examples 1 to 5 satisfied numerical value ranges such as the above. It is deemed that the above numerical value relationship results in good emission balance, high efficiency, and long life.

**[Table 5]**

| | | | | | | |
|---|---|---|---|---|---|---|
| Fluorescent unit | | | | | | |

| | | Evaluation element 1 | Evaluation element 2 | Evaluation element 3 | Evaluation element 4 | Evaluation element 5 |
|---|---|---|---|---|---|---|
| Thickness | X | 25 | 25 | 25 | 20 | 15 |
| | Y | 5 | 5 | 10 | 15 | 20 |
| Emission intensity | I(λBS) | 1 | 1 | 1 | 1 | 1 |
| | I(λGS) | 0.34 | 0.35 | 0.46 | 0.86 | 1.6 |
| Corresponding example | | Example 1 | Example 2 | Example 3 | Example 4 | Example 5 |
| Phosphorescent unit | | | | | | |

| | | Evaluation element 6 | Evaluation element 7 | Evaluation element 8 | Evaluation element 9 | Evaluation element 10 |
|---|---|---|---|---|---|---|
| Thickness | α | 15 | 18 | 25 | 30 | 35 |
| | β | 15 | 17 | 10 | 10 | 10 |
| Emission intensity | I(λRT) | 1 | 1 | 1 | 1 | 1 |
| | I(λGT) | 0.64 | 0.64 | 0.51 | 038 | 0.26 |
| Corresponding example | | Example 1 | Example 2 | Example 3 | Example 4 | Example 5 |

Emission characteristics in Examples 17 and 18, having the same layer build-up as in Examples 1 to 5 but the film thickness shown in Table 6, were assessed, and emission characteristics in Evaluation elements 11 to 14 of Examples 17 and 18 were also assessed, for reference. The film thickness in Example 17 is as given in Evaluation elements 11 and 13, and the film thickness of Example 18 is as given in Evaluation elements 12 and 14. The results are summarized in Table 6. Life was found to be shorter for D and N colors, and production of W, WW and L colors was difficult, when the above numerical value ranges were not satisfied.

**[Table 6]**

| Emission color | | D | N |
|---|---|---|---|
| | | Example 1 | Example 2 |
| CIE-x | | 0.325 | 0.346 |
| CIE-y | | 0.337 | 0.36 |
| Efficiency | | 1 | 1 |
| Life | | 1 | 1 |
| | | Example 17 | Example 18 |
| CIE-x | | 0.321 | 0.344 |
| CIE-y | | 0.342 | 0.371 |
| Efficiency | | 1.08 | 1.07 |
| Life | | 0.89 | 0.92 |
| Fluorescent unit | | | |
| | | Evaluation element 11 | Evaluation element 12 |
| Thickness | X | 30 | 24 |
| | Y | 5 | 3 |
| Emission intensity | I(λBS) | 1 | 1 |
| | I(λGS) | 0.28 | 0.27 |
| Corresponding example | | Example 17 | Example 18 |

| Phosphorescent unit | | | |
|---|---|---|---|
| | | Evaluation element 13 | Evaluation element 14 |
| Thickness | α | 10 | 13 |
| | β | 15 | 17 |
| Emission intensity | I(λRT) | 1 | 1 |
| | I(λGT) | 0.74 | 0.75 |
| Corresponding example | | Example 17 | Example 18 |

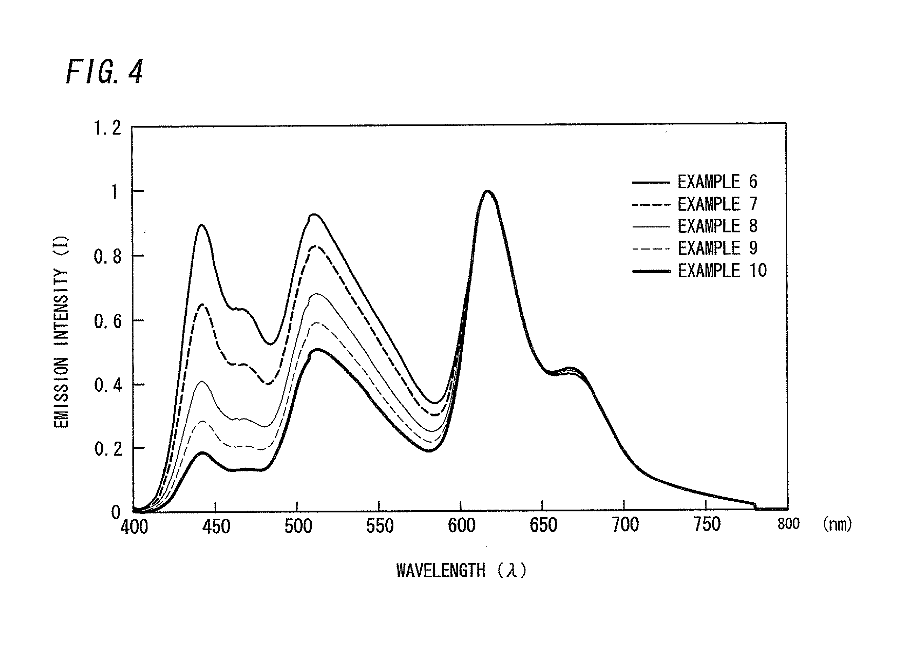

Table 7 shows the results of characteristic evaluation in a comparison between the organic electroluminescent elements of Examples 6 to 10 and Examples 1 to 5. Fig. 4 illustrates emission spectra of the organic electroluminescent elements of Examples 6 to 10.

The wavelengths at which the respective emitting dopants exhibit maximum emission intensity are as follows.
Ir(ppy)₃: λmax=520 nm (green phosphorescent light emitting-layer 11)
C545T: λmax=525 nm (green fluorescent light-emitting layer 21)
rubrene: λmax=560 nm (green fluorescent light-emitting layer 21)
The wavelength difference between the wavelength of the emitting dopant of the green phosphorescent light emitting-layer 11 and the wavelength of the emitting dopant of the green fluorescent light-emitting layer 21 is 5 nm in Examples 1 to 5, and 40 nm in Examples 6 to 10. This wavelength difference is found to be equal to the wavelength difference between the green emission wavelength (λGT) that exhibits maximum emission intensity in the phosphorescent light unit 1, and the green emission wavelength (λGS) that exhibits maximum emission intensity in the fluorescent light unit 2. That is, the relationship λGS-λGT=5<10 holds in Examples 1 to 5.

Table 7 summarizes that the organic electroluminescent elements of Examples 6 to 10, in which the green emitting dopant rubrene (λmax=560 nm) was used as the emitting dopant, had both lower efficiency and life than those of corresponding Examples 1 to 5. That is, the organic electroluminescent elements of Examples 1 to 5 were found to exhibit both higher efficiency and longer life than the organic electroluminescent elements of Examples 6 to 10.

**[Table 7]**

| Emission color | D | N | W | WW | L |
|---|---|---|---|---|---|
| | Example 1 | Example 2 | Example 3 | Example 4 | Example 5 |
| Efficiency | 1 | 1 | 1 | 1 | 1 |
| Life | 1 | 1 | 1 | 1 | 1 |
| | Example 6 | Example 7 | Example 8 | Example 9 | Example 10 |
| Efficiency | 0.98 | 0.97 | 0.99 | 0.92 | 0.86 |
| Life | 0.93 | 0.91 | 0.87 | 0.84 | 0.8 |

| | | | | | |
|---|---|---|---|---|---|
| * Efficiency and life values are relative values with respect to 1 for efficiency and life in the examples overhead | | | | | |

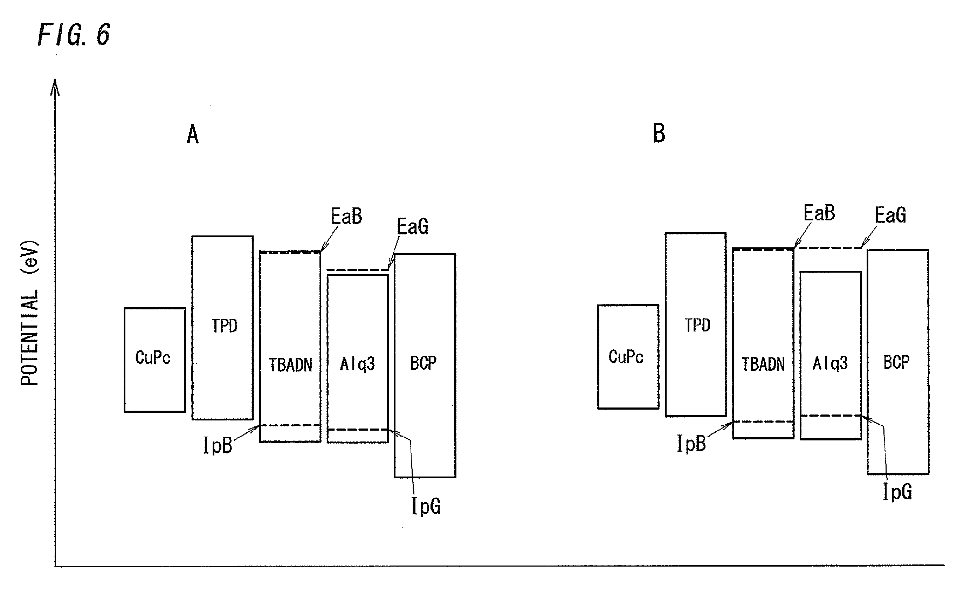

Table 8 shows a comparison of energy levels of the emitting dopants used in Examples 1 to 5 and Examples 11 to 15. Table 9 shows a comparison of the efficiency and life in Examples 1 to 5 and Comparative examples 11 to 15. Figs. 6A and 6B illustrate a comparison of potential levels for the energy levels of Examples 1 to 5 and energy levels in Examples 11 to 15, respectively.

As Table 8 indicates, a comparison between TBP, which is the emitting dopant of the blue fluorescent light-emitting layer 22 and C545T, which is the emitting dopant of the green fluorescent light-emitting layer 21 in Examples 1 to 5, reveals that the ionization potential (IpB) of TBP is -5.5 eV, which is greater than -5.6, the ionization potential (IpG) of C545T. The electron affinity (EaB) of TBP is -2.7 eV, which is greater than -3.0 eV, the electron affinity (EaG) of C545T. In Table 8, Ip denotes ionization potential, Ea denotes electron affinity, and the units are eV.

A comparison in Examples 11 to 15 between TBP, which is the emitting dopant of the blue fluorescent light-emitting layer 22 and coumarin 6, which is the emitting dopant of the green fluorescent light-emitting layer 21, reveals that the ionization potential (IpB) of TBP carrying -5.5 eV is smaller than that (IpG) of coumarin 6 carrying - 5.4 eV. The electron affinity (EaB) of TBP is -2.7 eV, which is identical to the electron affinity (EaG) of coumarin 6, namely -2.7 eV.

Fig. 6(a) illustrates the energy level relationships for Examples 1 to 5, and Fig. 6(b) illustrates the energy level relationship for Examples 11 to 15.

Table 9 summarizes that the organic electroluminescent elements of Examples 11 to 15, in which coumarin 6 (λmax=510 nm) was used as the green emitting dopant, exhibited lower efficiency and shorter life than those of Examples 1 to 5. That is, the organic electroluminescent elements of Examples 1 to 5 were found to boast higher efficiency and longer life than the organic electroluminescent elements of Examples 11 to 15.

**[Table 8]**

| | Blue emitting dopant (B) | Green emitting dopant (G) | |
|---|---|---|---|
| | TBP | C545T | coumarin 6 |
| Iₚ | -5.5 | -5.6 | -5.4 |
| Eₐ | -2.7 | -3.0 | -2.7 |
| λₘₐₓ | 462 | 525 | 510 |

**[Table 9]**

| Emission color | D | N | W | WW | L |
|---|---|---|---|---|---|
| | Example 1 | Example 2 | Example 3 | Example 4 | Example 5 |
| Efficiency | 1 | 1 | 1 | 1 | 1 |
| Life | 1 | 1 | 1 | 1 | 1 |
| | Example 11 | Example 12 | Example 13 | Example 14 | Example 15 |
| Efficiency | 1 | 0.98 | 0.95 | 0.92 | 0.88 |
| Life | 0.96 | 0.93 | 0.92 | 0.9 | 0.89 |

| | | | | | |
|---|---|---|---|---|---|
| * Efficiency and life values are relative values with respect to 1 for efficiency and life in the examples overhead | | | | | |

The above results are summarized in Table 10.
The table indicates that Examples 1 to 5 afforded both high efficiency and long life.

**[Table 10]**

| Emission color | D | N | W | WW | L |
|---|---|---|---|---|---|
| | Example 1 | Example 2 | Example 3 | Example 4 | Example 5 |
| Efficiency | 1 | 1 | 1 | 1 | 1 |
| Life | 1 | 1 | 1 | 1 | 1 |

| | Example 6 | Example 7 | Example 8 | Example 9 | Example 10 |
|---|---|---|---|---|---|
| Efficiency | 0.98 | 0.97 | 0.99 | 0.92 | 0.86 |
| Life | 0.93 | 0.91 | 0.87 | 0.84 | 0.8 |

| | Example 11 | Example 12 | Example 13 | Example 14 | Example 15 |
|---|---|---|---|---|---|
| Efficiency | 1 | 0.98 | 0.95 | 0.92 | 0.88 |
| Life | 0.96 | 0.93 | 0.92 | 0.9 | 0.89 |

| | Example 17 | Example 18 | | Example 16 | |
|---|---|---|---|---|---|
| Efficiency | 1.18 | 1.07 | | 0.74 | |
| Life | 0.89 | 0.92 | | 0.93 | |

| | Comparative example 1 | Comparative example 2 | Comparative example 3 | Comparative example 4 | Comparative example 5 |
|---|---|---|---|---|---|
| Efficiency | 1.09 | 1.09 | 0.93 | 0.88 | 0.84 |
| Life | 0.82 | 0.82 | 0.79 | 0.76 | 0.65 |

| | | | | | |
|---|---|---|---|---|---|
| * Efficiency and life values in the comparative examples are relative values with respect to 1 for efficiency and life in the respective topmost example in the same column | | | | | |

## Claims

1. An organic electroluminescent element, comprising: a red phosphorescent light emitting-layer, a green phosphorescent light emitting-layer, a blue fluorescent light-emitting layer and a green fluorescent light-emitting layer.

2. The organic electroluminescent element according to claim 1, comprising: a phosphorescent light unit that has the red phosphorescent light emitting-layer and the green phosphorescent light emitting-layer; and a fluorescent light unit that has the blue fluorescent light-emitting layer and the green fluorescent light-emitting layer, wherein
the phosphorescent light unit and the fluorescent light unit are connected via an interlayer.

3. The organic electroluminescent element according to claim 1, comprising: an anode; a cathode; a phosphorescent light unit that has the red phosphorescent light emitting-layer and the green phosphorescent light emitting-layer; and a fluorescent light unit that has the blue fluorescent light-emitting layer and the green fluorescent light-emitting layer, wherein
the phosphorescent light unit is disposed further towards the cathode side than the fluorescent light unit.

4. The organic electroluminescent element according to claim 2, comprising: an anode; a cathode; the phosphorescent light unit; and the fluorescent light unit, wherein
the phosphorescent light unit is disposed further towards the cathode side than the fluorescent light unit.

5. The organic electroluminescent element according to claim 1, comprising: a phosphorescent light unit that has the red phosphorescent light emitting-layer and the green phosphorescent light emitting-layer; and a fluorescent light unit that has the blue fluorescent light-emitting layer and the green fluorescent light-emitting layer, wherein
in the phosphorescent light unit, a ratio [I(λGT)/I(λRT)] of a maximum intensity [I(λRT)] at a red emission wavelength (λRT) and a maximum intensity [I(λGT)] at a green emission wavelength (λGT) satisfies I(λGT)/I(λRT)<0.65; and in the fluorescent light unit, a ratio [I(λGS)/I(λBS)] of a maximum intensity [I(λBS)] at a blue emission wavelength (λBS) and a maximum intensity [I(λGS)] at a green emission wavelength (λGS) satisfies I(λGS)/I(λBS)>0.3.

6. The organic electroluminescent element according to any one of claims 2 to 4, comprising the phosphorescent light unit and the fluorescent light unit, wherein
in the phosphorescent light unit, a ratio [I(λGT)/I(λRT)] of a maximum intensity [I(λRT)] at a red emission wavelength (λRT) and a maximum intensity [I(λGT)] at a green emission wavelength (λGT) satisfies I(λGT)/I(λRT)<0.65; and in the fluorescent light unit, a ratio [I(λGS)/I(λBS)] of a maximum intensity [I(λBS)] at a blue emission wavelength (λBS) and a maximum intensity [I(λGS)] at a green emission wavelength (λGS) satisfies I(λGS)/I(λBS)>0.3.

7. The organic electroluminescent element according to claim 1, comprising: a phosphorescent light unit that has the red phosphorescent light emitting-layer and the green phosphorescent light emitting-layer; and a fluorescent light unit that has the blue fluorescent light-emitting layer and the green fluorescent light-emitting layer, wherein
an absolute value of a wavelength difference between a green emission wavelength (λGT) in the phosphorescent light unit and a green emission wavelength (λGS) in the fluorescent light unit is not greater than 10 nm.

8. The organic electroluminescent element according to any one of claims 2 to 6, comprising the phosphorescent light unit and the fluorescent light unit, wherein
an absolute value of a wavelength difference between a green emission wavelength (λGT) in the phosphorescent light unit and a green emission wavelength (λGS) in the fluorescent light unit is not greater than 10 nm.

9. The organic electroluminescent element according to any one of claims 1 to 8, wherein an ionization potential (IpB) of an emitting dopant in the blue fluorescent light-emitting layer is greater than an ionization potential (IpG) of an emitting dopant in the green fluorescent light-emitting layer; and the electron affinity (EaB) of an emitting dopant in the blue fluorescent light-emitting layer is greater than the electron affinity (EaG) of an emitting dopant in the green fluorescent light-emitting layer.

10. The organic electroluminescent element according to any one of claims 1 to 9, wherein a mixed color of emission colors of the red phosphorescent light emitting-layer, the green phosphorescent light emitting-layer, the blue fluorescent light-emitting layer and the green fluorescent light-emitting layer is any of a W color, a WW color and an L color.

11. The organic electroluminescent element according to any one of claims 1 to 10, wherein a maximum intensity (IR) in a red wavelength region, a maximum intensity (IG) in a green wavelength region and a maximum intensity (IB) in a blue wavelength region become, in this order, weaker (IR>IG>IB).

12. The organic electroluminescent element according to claims 1 to 11, wherein the red phosphorescent light emitting-layer comprises a red phosphorescent emitting dopant that emits red phosphorescent light; and the red phosphorescent emitting dopant is formed of one substance selected from the group consisting of bis-(3-(2-(2-pyridyl)benzothienyl)mono-acetylacetonate)iridium (III), bis(2-phenylbenzothiazolata)(acetylacetanate)iridium (III), and 2,3,7,8,12,13,17,18-octaethyl-21H,23H-porphyrin platinum (II).

13. The organic electroluminescent element according to claims 1 to 12, wherein the green phosphorescent light emitting-layer comprises a green phosphorescent emitting dopant that emits green phosphorescence; and the green phosphorescent emitting dopant is formed of one substance selected from the group consisting of fac-tris(2-phenylpyridine)iridium, bis(2-phenylpyridine)(acetylacetonate)iridium (III), and tris[2-(p-tolyl)pyridine]iridium (III).

14. The organic electroluminescent element according to claims 1 to 13, wherein the blue fluorescent light-emitting layer comprises a blue fluorescent emitting dopant that emits blue fluorescent light; and the blue fluorescent emitting dopant is formed of one substance selected from the group consisting of 1-tert-butyl perylene (TBP), 4,4'-bis(9-ethyl-3-carbazovinylene)-1,1'-biphenyl, and perylene.

15. The organic electroluminescent element according to claim 14, wherein the blue fluorescent light-emitting layer further comprises a charge transfer aid dopant; and the charge transfer aid dopant is formed of one substance selected from the group consisting of 4,4'-bis[N-(naphthyl)-N-phenyl-amino] biphenyl, N,N'-bis(3-methylphenyl)-N,N'-bis(phenyl)-benzidine, and N,N'-bis(3-methylphenyl)-N,N'-bis(phenyl)-9,9-spirobifluorene.

16. The organic electroluminescent element according to claims 1 to 15, wherein the green fluorescent light-emitting layer comprises a green fluorescent emitting dopant that emits green fluorescent light; and the green fluorescent emitting dopant is formed of one substance selected from the group consisting of 2,3,6,7-tetrahydro-1,1,7,7,-tetramethyl-1H,5H,11H-10-(2-benzothiazolyl)quinolizino-[9,9a,1gh]coumarin, N,N'-dimethyl-quinacridone, coumarin 6, and rubrene.

17. The organic electroluminescent element according to claim 16, wherein a host into which the green fluorescent emitting dopant is incorporated is formed of one substance selected from the group consisting of tris(8-oxoquinoline)aluminum (III), 9,10-di-(2-naphthyl)anthracene and bis(9,9'-diarylfluorene).

18. The organic electroluminescent element according to claim 16 or 17, wherein the doping concentration of the green fluorescent emitting dopant ranges from 1 to 20 mass%.
